Europäisches Patentamt

European Patent Office

Office européen des brevets

(19)

(11) **EP 0 545 059 B1**

(12) **EUROPÄISCHE PATENTSCHRIFT**

(45) Veröffentlichungstag und Bekanntmachung des Hinweises auf die Patenterteilung:
**19.03.1997  Patentblatt 1997/12**

(51) Int Cl.$^6$: **H03K 17/06**

(21) Anmeldenummer: **92118172.3**

(22) Anmeldetag: **23.10.1992**

(54) **Schaltungsanordnung zum Schalten hoher kapazitiver Lasten bei bestimmtem Spannungspegel**

Limit arrangement for switching high capacitive loads at given voltage level

Montage pour la commutation de charges capacitives élevées à niveau de tension déterminé

(84) Benannte Vertragsstaaten:
**DE FR GB**

(30) Priorität: **03.12.1991  DE 4139762**

(43) Veröffentlichungstag der Anmeldung:
**09.06.1993  Patentblatt 1993/23**

(73) Patentinhaber: **Daimler-Benz Aerospace Aktiengesellschaft**
**81663 München (DE)**

(72) Erfinder: **Sodeikat, Dieter**
**W-8021 Baierbrunn (DE)**

(56) Entgegenhaltungen:
- **ELECTRONICS & WIRELESS WORLD Bd. 94, Nr. 1630, August 1988, SURREY GB Seiten 748 - 750 DONALDSON 'The Mosmarx voltage multiplier'**
- **JP-A 02 164 268**

## Beschreibung

Die Erfindung betrifft eine Schaltungsanordnung zum Schalten hoher kapazitiver Lasten bei bestimmten Spannungspegeln. Solche kapazitiven Lasten können z. B. sein: Treiberbausteine für die Ansteuerung von ladungsgekoppelten Bausteinen (CCD's), Treiber zur Steuerung von anderen Sensoren oder Aktoren und Treiber für Taktgeber. Die dabei verwendeten Techniken können Metalloxid-Halbleiter, insbesondere CMOS-Techniken oder HC-MOS- oder AHC-MOS-Techniken, oder MOS-FET-Schalter oder andere Hochleistungsschalter als integrierte Schaltkreise sein. Die Anforderungen, welche z. B. insbesondere für Raumfahrtanwendungen an derartige Schalter bzw. Steuerungstreiber gestellt werden, sind hoch, insbesondere sollen sie verlustarm und strahlungsfest von hoher Qualität und trotzdem preiswert sein.

Den derzeitigen Stand der Technik gibt recht gut der Aufsatz von Herbert Sax und Michael Barou "Smart-Power" in Elektronik 7/1991, Seite 152 ff. wieder. Im Stand der Technik wird jeweils nur eine einzige Treiberstufe verwendet, um verlustarm arbeiten zu können. Um die Eingangslogik dort TTL-kompatibel zu erhalten, wird ein konstanter Spannungsabfall erzeugt.

Aus der Literaturstelle: Donaldson, P.E.K.: "The Mosmarx voltage multiplier", in: Electronics & Wireless World, Vol. 94, Nr. 1630, Aug. 1988, S. 748 - 750 ist eine Schaltung bekannt geworden, mit der hohe kapazitive Lasten schaltbar sind. Die Schaltung ist als mehrstufige Kaskadenschaltung ausgelegt, bei der jede gleichartige Stufe spannungserhöhend wirkt. Als besonders nachteilig wirkt sich die schaltungstypische Eigenschaft aus, daß die Schaltelemente der höheren Kaskadenstufen jeweils für das entsprechende Vielfache der Versorgungsspannung ausgelegt sein müssen. Dies reduziert jedoch die Schaltgeschwindigkeit der gesamten Kaskadenschaltung.

Es ist deshalb Aufgabe der Erfindung, ausgehend von der Anwendung handelsüblicher integrierter Halbleiter-Bausteine (IC's) mit etwa 5 V Versorgungs- bzw. Ausgangsspannung eine Schaltungsanordnung zum Schalten hoher kapazitiver Lasten zu entwerfen, die nur eine Spannungsquelle benötigt und deren Bauelemente nur für die Höhe dieser Spannungsquelle ausgelegt sein müssen.

Gelöst wird diese Aufgabe erfindungsgemäß durch die im Kennzeichen aufgeführten Merkmale des Patentanspruchs.

Die wesentlichsten Vorteile der Erfindung sind:

- die Erfüllung der eingangs genannten Forderungen, insbesondere für Raumfahrtanwendungen,
- sehr niedrige Verlustleistung im Ruhezustand "CMOS",
- niedrige frequenzproportionale innere Verluste "CMOS",
- höherer Wirkungsgrad beim Betrieb mit großen kapazitiven Lasten,
- sehr niedrige Treiberleistung "CMOS"
- niedrige Betriebsspannungen,
- Betrieb mit sehr hohen kapazitiven Lasten,
- keine Offsetspannung bezüglich Bezugspotential (Ground),
- sehr kurze Verzögerungszeiten,
- kurze Anstiegs- und Abfallzeiten und
- die Vorteile der verwendeten Bauteile

  preiswerte Serienprodukte

  nach MIL- und Raumfahrtspezifikation erhältlich "High Rel"

  in strahlungsfester Form erhältlich "Rad Hard".

Die Erfindung eignet sich gleichermaßen als Treiber bei der Ansteuerung von Sensoren sowie bei Aktoren. Besonders bewährt hat sie sich für die Ansteuerung von ladungsgekoppelten Vorrichtungen, die schnell schalten müssen und große kapazitive Lasten enthalten. Sie sind ferner besonders geeignet als Wechselspannungstreiber und Treiber, deren statischer Zustand "Low" ist. Beim Ausgangspegel "High" ist die Stufenschaltung im statischen Betrieb allerdings nicht mit besonderen ohmschen Lasten belastbar, was jedoch für die vorgenannten Anwendungen unerheblich ist. Die erfindungsgemäße Schaltungsanordnung erreicht Überschwinger und Unterschwinger $\leq 1$ %. Die Eingangsspannung bzw. Versorgungsspannung kann um etwa $\pm$ 15 % schwanken. Die Anstiegszeiten bzw. Abfallzeiten liegen im ns-Bereich, der Betriebsstrom im Leerlauf im mA-Bereich und die Betriebsleistung im Leerlauf im mW-Bereich, das Tastverhältnis in einem Ausführungsbeispiel bei einer Taktfrequenz von 5 MHz bei 50 %. Die angewendeten kapazitiven Lasten lagen zwischen etwa 500 pF und nahezu 1000 pF.

In den Ausführungsbeispielen zeigen:

Fig. 1 zwei Stufen mit integriertem Halbleiterbaustein,
Fig. 2 drei Stufen mit integrierten Halbleiterbausteinen,
Fig. 3 vier Stufen mit integrierten Halbleiterbausteinen.

Bei allen Ausführungsbeispielen wird eine Erhöhung der Ausgangsspannung der Schaltung durch Kaskadierung mehrerer integrierter Schaltkreise erreicht. Hierbei steigt die Ausgangsspannung etwa um den Faktor n gegenüber der Versorgungsspannung an, je nach Anzahl der Stufen.

## Funktionsbeschreibung:

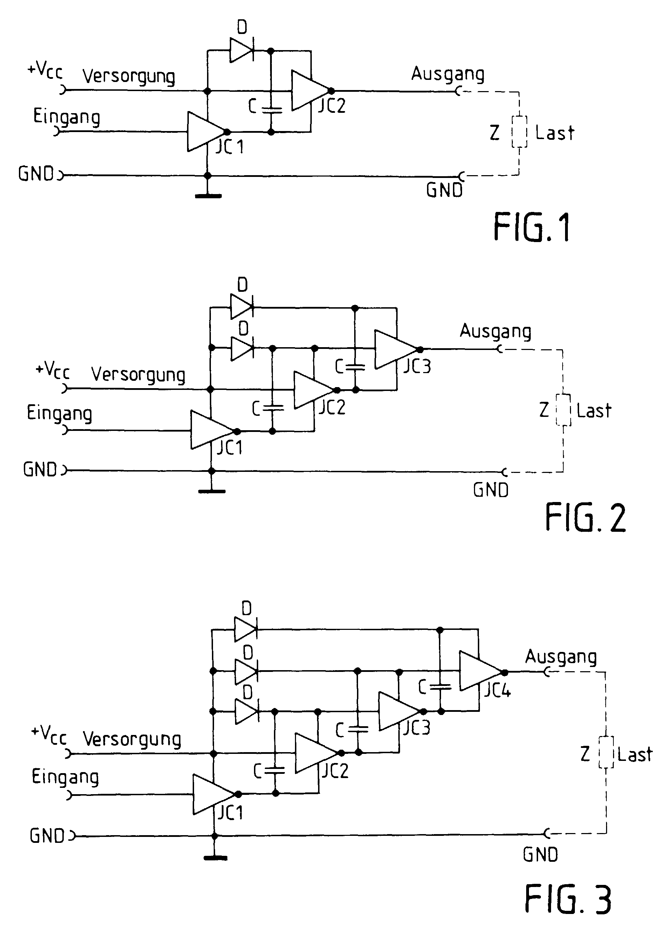

Jede kaskadierte Schaltstufe (Fig. 1, 2, 3 - IC 2/3/4) arbeitet nach dem gleichen Prinzip. Im Grundzustand, Eingang logisch "High" (Vcc), werden alle IC's am Eingang auf logisch "High" und bezüglich ihrer negativen Versorgung am Ausgang auf logisch "Low" geschaltet. Somit ist am Ausgang der gesamten Stufe auf logisch "Low" mit einem Innenwiderstand, der sich aus der Serienschaltung aller IC-Innenwiderstände (bei log "Low") ergibt. Gleichzeitig werden alle Ladekondensatoren C über die Dioden D auf die Spannung $V_{CC}$-$V_{DD}$ aufgeladen ($V_{DD}$ = Diodendurchlaßspannung).

Beim Umschalten des Eingangs von IC 1 auf logisch "LOW" (Ground) springt dessen Ausgang auf logisch "High". Alle kaskadierten IC's erhalten dadurch am Eingang auch logisch "Low" und alle Ausgänge logisch "High". Da sich aber in diesem Zustand die Spannung jeder kaskadierten Stufe auf den Ausgang der vorhergehenden addiert, erscheint am Ausgang die Spannung:

$$U_{Ausgang} = V_{CC} + (n-1)(V_{CC} - V_{DD})$$

n =      Anzahl der kaskadierten Stufen
$V_{CC}$ =    Versorgungsspannung
$V_{DD}$ =    Diodendurchlaßspannung

Der Innenwiderstand setzt sich aus der Summe aller IC's im logischen "High"-Zustand zusammen.

Es muß beachtet werden, daß bei logisch "High" am Ausgang der Ausgangsstrom aus den Ladekondensatoren entnommen wird. Aus diesem Grunde muß bei ohmschen Lasten das Tastverhältnis und die Stufendimensionierung aufeinander angepaßt werden, damit die Dachschräge des Pulses im "High"-Zustand nicht zu groß wird.

Bei kapazitiven Lasten wird lediglich ein Teil der Kapazität der Ladekondensatoren auf die Lastkapazität umgeschichtet, weshalb keine Dachschräge auftritt.

Außerdem ist zu beachten, daß die IC's (IC 1/2 usw.) auf verschiedenen Potentialen liegen, weshalb für jede Stufe ein separater IC verwendet werden muß.

Zur Erhöhung des Ausgangsstroms sind in jedem IC alle Inverterstufen parallel geschaltet.

Erläuterungen der gewählten Begriffe im Sinne der Erfindung:

Schaltgeschwindigkeit:

Die größtmögliche Geschwindigkeit ist durch den Eigenanstieg der IC's und deren Stromergiebigkeit bei Lastaufschaltung bestimmt.

Bei AC-MOS-IC's beträgt die erreichbare Anstiegs- und Abfallzeit ohne Last ca. 10 bis 20 ns.

Bei Parallelschaltung der Gatter eines IC's (6 bis 8 Gatter) und Lasten von 1 nF beträgt die Anstiegs- und Abfallzeit ca. 15 bis 25 ns.

Kapazitive Belastung:

Die kapazitive Belastung kann beliebig sein, Begrenzung ist die Strombelastbarkeit (Puls und DC) der IC's. Aus diesen Daten läßt sich dann auch die maximale Betriebsfrequenz und An- und Abfallzeit errechnen. Sinnvoll sind Lasten bis ca. 10 nF bei AC-MOS-Bausteinen, bei denen alle internen Gatter parallel geschaltet sind.

Strahlenfestigkeit:

Die Strahlenfestigkeit der gesamten Schaltung hängt nur von der Resistenz der verwendeten IC's ab, bezüglich Dosis und Strahlenart. Als Beispiel können kommerzielle Fairchild AC-MOS-IC's bis ca. 500 krad eingesetzt werden.

Qualifikation, High Rel:

Der Qualifikationsgrad und die Zuverlässigkeit (Ausfallrate) hängen lediglich von den verwendeten Bauteilen ab.

Die Ausfallrate setzt sich aus der Summe der Ausfallraten aller verwendeten Bauteile zusammen.

**Patentansprüche**

1.  Kaskadenschaltung zum Schalten hoher kapazitiver Lasten mit wenigstens zwei hintereinander angeordneten Schaltstufen, wobei jede einer ersten Eingangsstufe (IC 1) nachfolgende Stufe als gleichartige spannungserhöhende Schaltung aus wenigstens einem Inverter (IC2), mindestens einer Diode (D) und mindestens einem Ladekondensator (C) besteht, **dadurch gekennzeichnet,** daß jede nachfolgende Stufe (IC2, D, C) einen integrierten Halbleiterbaustein (IC2) mit mehreren parallelgeschalteten Invertern aufweist und daß der Ladekondensator (C) an die beiden Spannungsversorgungsanschlüsse der parallel geschalteten Inverter (IC2) angeschlossen ist, wobei der eine Spannungsversorgungsanschluß der parallel geschalteten Inverter einer jeden der ersten Stufe (IC1) nachfolgenden Stufe (IC2, D, C) mit dem Ausgang der vorhergehenden Stufe (IC1) und der andere Spannungsversorgungsanschluß über die genannte Diode (D) mit einem Versorgungspotential (+ $V_{CC}$) verbunden ist und wobei der Eingang einer jeden der ersten Stufe nachfolgenden Stufe mit dem anderen Versorgungsanschluß der vorhergehenden Stufe verbunden ist.

**Claims**

1.  A cascade connection for switching high capacitive loads, having at least two switching stages disposed in series, wherein each stage following a first input stage (IC 1) consists, as a voltage booster circuit of the same kind, of at least one inverter (IC2), of at least one diode (D) and of at least one charging capacitor (C), **characterised in that** each following stage (IC2, D, C) comprises an integrated semiconductor component (IC2) with a plurality of inverters connected in parallel, and that the charging capacitor (C) is connected to the two voltage supply connections of the inverters (IC2) which are connected in parallel, wherein one voltage supply connection of the inverters which are connected in parallel of each stage (IC2, D, C) following the first stage (IC1) is connected to the output of the preceding stage (IC1) and the other voltage supply connection is connected via the said diodes (D) to a supply potential (+ $V_{CC}$), and wherein the input of each stage following the first stage is connected to the other supply connection of the preceding stage.

**Revendications**

1. Circuit en cascade pour la commutation de charges capacitives élevées, avec au moins deux étages de commutation en série, chaque étage suivant un premier étage d'entrée (IC 1) étant constitué, en tant que circuit identique élévateur de tension, d'au moins un inverseur (IC 2), d'au moins une diode (D) et d'au moins un condensateur de charge (C), **caractérisé** par le fait que chaque circuit suivant (IC 2, D, C) présente un composant semi-conducteur intégré (IC 2) avec plusieurs inverseurs montés en parallèle et que le condensateur de charge (C) est relié aux deux connexions d'alimentation en tension des inverseurs (IC 2) montés en parallèle, l'une des connexion d'alimentation en tension des inverseurs montés en parallèle de chaque étage (IC 2, D, C) suivant le premier étage (IC 1) étant reliée à la sortie de l'étage précédent (IC 1) et l'autre connexion d'alimentation en tension, en passant par la diode précitée (D), à un potentiel d'alimentation (+ $V_{CC}$) et l'entrée de chaque étage suivant le premier étage étant reliée à l'autre connexion d'alimentation de l'étage précédent.

FIG.1

FIG.2

FIG.3